# EUROPÄISCHE PATENTANMELDUNG

(11) **EP 1 607 457 A2**
(43) Veröffentlichungstag der Anmeldung: **21.12.2005**
(21) Anmeldenummer: 05104783.5
(22) Anmeldetag: 02.06.2005
(51) Int. Cl.: C09J 7/02, C09J 11/04

(54) **Elektrisch anisotrop leitfähiger Schmelzkleber zur Implantierung von elektrischen Modulen in einen Kartenkörper**

(30) Priorität: 18.06.2004 DE 102004029589
(71) Anmelder: tesa AG, 20253 Hamburg (DE)
(72) Erfinder: HUSEMANN, Marc, Dr., 22605, Hamburg (DE); KLOSE, Maren, 21217, Seevetal (DE)
(74) Vertreter: Stubbe, Andreas

(57) **Zusammenfassung**

Klebstofffolie, insbesondere zur Verklebung von elektrischen Modulen in Kartenkörpern, bestehend zumindest aus einer Schicht eines Klebesystems auf Basis zumindest einer hitze-aktivierbaren Klebemasse, dadurch gekennzeichnet, dass
- die Erweichungstemperatur des Klebesystems im Bereich von 65 °C bis 165 °C liegt,
- dem Klebesystem elektrisch leitfähige Partikel beigemischt sind,
   wobei die Partikel im Durchschnitt einen Durchmesser von 25 bis 100 µm aufweisen, mit der Maßgabe, dass der durchschnittliche Durchmesser der leitfähigen Partikel größer ist als die Schichtdicke des Klebesystems,
- die leitfähigen Partikel einen Kupfer- oder Nickelkern aufweisen.

## Beschreibung

Die Erfindung betrifft einen anisotrop elektrisch leitfähigen Schmelzkleber zur Verklebung von elektrischen Modulen in Kartenkörpern sowie zur dauerhaften Herstellung eines elektrischen Kontaktes zwischen elektrischem Modul und Antenne im Kartenkörper.

Zur Implantierung von elektrischen Modulen in Kartenkörpern sind im Stand der Technik bereits eine Vielzahl von Klebstofffolien oder Fügeverfahren bekannt. Ziel dieser Implantierungen ist die Herstellung von Telefonkarten, Kreditkarten, Parkautomatkarten, Versicherungskarten, etc. Beispiele für die entsprechenden Verklebungsverfahren finden sich z.B. in den Patentschriften EP 0 842 995, EP 1 078 965 und DE 199 48 560.

In diesem Bereich der Verklebung steigen aber kontinuierlich die Anforderungen an das Klebesystem. So muss der Kleber eine gute Haftung auf Polycarbonat, auf ABS, PVC und PET aufweisen, aber ebenso eine gute Haftung zum elektrischen Modul. Hier wird in der Regel auf Epoxy-Materialien, Polyestern oder Polyimiden verklebt. Früher wurden Cyan-Acrylate als Flüssigkleber eingesetzt, die den Vorteil aufwiesen, dass eine optimale Benetzung des Kartenkörpers sowie des elektrischen Chips erzielt wurde. Diese Technologie ist aber im Aussterben begriffen, da die Prozesse sehr langsam sind. Das Lösemittel verdampfte nur langsam aus der Kavität des Kartenkörpers, die Spritzen zur Dosierung verstopften beim Stillstand durch Austrocknen und waren zudem schlecht dosierbar und der Flüssigkleber benötigte ebenfalls eine gewisse Zeit zum Aushärten. Als Resultat war die Qualität der Verklebung recht schlecht.

Schmelzhaftkleber zeigen sich den Flüssigklebern deutlich überlegen. Dennoch ist die Auswahl an geeigneten Verbindungen auch hier sehr eingeschränkt, da sehr hohe Anforderungen an diese Fügetechnik gestellt werden.

Für die Herstellung der sogenannten Dual Interface Smart Cards stellt sich ein weiteres Problem, da der Kleber hier auch noch die Funktion der anisotropen elektrischen Leitfähigkeit übernehmen muss. Solche anisotrop leitfähigen Kleber sind bereits seit langem bekannt. In einfachster Weise werden dem Kleber elektrisch leitfähige Partikel in einer bestimmten Menge zugemischt. Durch die Wahl der Konzentration kann vermieden werden, dass eine Leitfähigkeit in XY-Richtung ausgebildet wird. Die elektrische Leitfähigkeit in Z-Richtung wird dadurch erreicht, dass die elektrisch leitfähigen Partikel teilweise im Durchmesser größer sind als die Schichtdicke des Klebers. Nach der Verpressung entsteht somit der direkte Kontakt zwischen den zu verbindenden elektrischen Kontakten.

In der Patentliteratur sind bereits eine Vielzahl von anisotrop leitfähigen Klebemassen beschrieben. In US 4,606,962 werden Transfer-Klebebänder beschrieben, die elektrisch leitfähige und thermisch leitfähige Partikel enthalten. Die Partikel werden zusammengedrückt bei der Ausübung von Druck und Temperatur. Um dies zu erreichen, sind die Partikel mit zwei Schichten ausgestattet. Bei Temperatur-Aktivierung schmilzt entweder der Kern oder die Außenhülle des elektrisch leitfähigen Partikels. Solche leichtschmelzenden Verbindungen stellen z.B. Blei-Legierungen dar. Für die Anwendung im Smart-Card Bereich sind solche Systeme aber nicht geeignet, da zur Herstellung der Verklebungsfestigkeit ebenfalls die Klebematrix aufgeschmolzen wird und somit Phasenseparationen auftreten können, die im ungünstigsten Fall eine Verklebung zwischen Pad der Antenne und Chipmodul verhindern.
Weiterhin besteht durch die Aufschmelzung der elektrisch leitfähigen Schicht die Gefahr eines Kurzschlusses, da im Bereich die Aufschmelzung die elektrisch leitfähige Fläche bedeutend vergrößert wird.

In US 5,499,730 wird ein Verfahren zur Herstellung von anisotrop elektrisch leitfähigen Klebebändern beschrieben. Hier werden die entsprechenden Partikel in regelmäßigen Abständen auf die Klebemasse gelegt, da ansonsten bei der Verarbeitung aus Extrusion befürchtet wird, dass die Partikel im Extrusionsprozess zerstört werden.

In US 5,685,939 wird ein Verfahren zur Ausrichtung von elektrisch leitfähigen Partikeln in Z-Richtung beschrieben. Die Ausrichtung erfolgt über elektromagnetische Strahlung. Dieses Verfahren ist nur sinnvoll für längliche oder nadelförmige Partikel.

In US 6,042,894 wird die Verwendung von elektrisch leitfähigen Partikeln beschrieben.

In US 6,452,111 werden spezielle elektrisch leitfähige Partikel mit einem Durchmesser zwischen 10 und 90 nm eingesetzt. Diese Partikel sind nicht für den Einsatz in Dual Interface Smart Cards geeignet, da die Verklebungsschichtdicken zu gering sind. Oberflächenrauhigkeiten aus der Fräsung der Karte und der elektrischen Module könnten nicht mehr durch den Kleber kompensiert werden.

In US 6,451,875 wird die Verwendung von elektrisch leitfähigen Partikeln mit einem elastischen Kern beschrieben. Die Elastizität wird z.B. durch ein Polymer erreicht. Die anisotrop leitfähigen Kleber werden zur Verklebung von Halbleitern eingesetzt. Für den Einsatz in Dual Interface Smart Cards sind diese Kleber aber nicht geeignet. Die Karten müssen einer Biegebeanspruchung standhalten. Dadurch wird eine stetige Kraft auf die Partikel ausgeübt, so dass die elektrisch leitfähige Schicht bei Dauerbeanspruchung aufbrechen würde.

In US 6,426,021 wird eine anisotrop leitfähige Klebemasse basierend auf ein Reaktivsystem und elektrisch leitfähigen Partikeln zur Verklebung von IC-Chips vorgeschlagen. Reaktivsysteme weisen aber den Nachteil auf, dass durch Reaktionen Sustanzen freigesetzt werden können, die die Korrosion der elektrisch leitfähigen Partikel begünstigen oder als gasförmige Komponente einen Gegendruck aufbauen und somit der Verklebung entgegenwirken.

Ein wichtiges Kriterium für die Anwendung sind weiterhin Temperaturschwankungen sowie der Einfluss von Feuchtigkeit, da diese Karten in der späteren Benutzung sowohl hohe als auch tiefe Temperaturen stand halten und zum Teil auch einmal einen Waschdurchgang überstehen müssen. Dementsprechend sollte der Kleber bei tiefen Temperaturen nicht verspröden, bei hohen Temperaturen nicht verflüssigen und eine geringe Tendenz zur Aufnahme von Wasser besitzen.

Der Erfindung liegt in Anbetracht dieses Standes der Technik die Aufgabe zu Grunde, eine anisotrop elektrisch leitfähige Klebstofffolie zum Implantieren von elektrischen Modulen in einen Kartenkörper anzugeben, welche die oben genannten Kriterien erfüllt.

Erfindungsgemäß wird die Aufgabe gelöst durch eine anisotrop leitfähige Klebstofffolie, bestehend zumindest aus einer Schicht eines Klebesystems auf Basis zumindest einer hitze-aktivierbaren Klebemasse, wobei die Erweichungstemperatur des Klebesystems im Bereich von 65 °C bis 165 °C liegt und wobei dem Klebesystem elektrisch leitfähige Partikel beigemischt sind, wobei weiterhin die Partikel im Durchschnitt einen Durchmesser von 25 bis 100 µm aufweisen, mit der Maßgabe, dass der durchschnittliche Durchmesser der leitfähigen Partikel größer ist als die Schichtdicke des Klebesystems.
Die Angaben der Erweichungstemperatur erfolgen unter Bezug auf das Messverfahren gemäß DIN 53460.

Insbesondere erfindungsgemäß vorteilhaft ist eine Klebstofffolie, bei der die zugesetzten leitfähigen Partikel einen Kupfer- oder Nickelkern aufweisen. und/oder bei der die leitfähigen Partikel eine Gold- oder eine Silberummantelung aufweisen.

Besonders vorteilhaft ist eine Klebstofffolie, bestehend aus einem Thermoplast und optional einem oder mehrer Harze, wobei
a) das Klebesystem eine Erweichungstemperatur von größer 65°C und kleiner 165°C aufweist
b) dem Klebesystem elektrisch leitfähige Partikel mit einem Kupfer oder Nickelkern sowie einer Silbermetallummantelung zu einem Anteil von 2 bis 60 Gew.-% an der Klebemasse homogen beigemischt ist
c) die Partikel im Durchschnitt einen Durchmesser von 25 bis 100 µm aufweisen, wobei der durchschnittliche Durchmesser zumindest 5 µm größer ist als die Schichtdicke der Klebemasse.

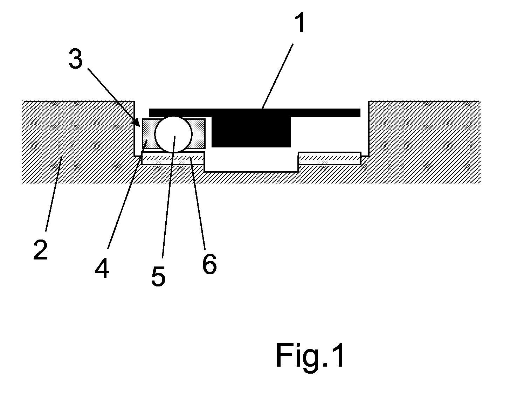

Die Verklebung des elektrischen Moduls mit einem Kartenkörper ist in Abbildung 1) schematisch dargestellt. Dabei bezeichnen 1 das Dual Interface Modul, 2 den Kartenkörper, 3 die erfindungsgemäße Klebstofffolie, bestehend aus der Klebemasse 4 und den beigemengten elektrisch leitfähigen Partikeln 5, und 6 die Antenne Die erfinderische temperatur-aktivierbare Klebemasse weist in einer bevorzugten Ausführungsform eine Schichtdicke zwischen 20 und 95 µm, in einer besonders bevorzugten Ausführungsform eine Schichtdicke von 30 bis 80 µm auf.

### Hitze-aktivierbare Klebemasse

Die hitzeaktivierbare Klebemasse besitzt zur Verklebung des elektrischen Moduls eine gute Haftung zu Epoxy-Materialien, Polyestern und Polyimiden und zur Verklebung auf Kartenkörpern eine gute Haftung zu PC, ABS, PVC und PET. In einer sehr bevorzugten Vorgehensweise werden thermoplastische Materialien eingesetzt, wie z.B. Polyurethane, Polyester, Polyamide, Ethylenvinylacetate, Synthesekautschuke, wie z.B. Styrolisopren Di- und Triblockcopolymere (SIS), Styrolbutadien Di- und Triblockcopolymere (SBS), Styrolethylenbutadien Di- und Triblockcopolymer (SEBS), Polyvinylacetat, Polyimide, Polyether, Copolyamide, Copolyester, Polyolefine, wie z.B. Polyethylen, Polypropylen, oder Poly(metha)crylate. Die Aufzählung besitzt keinen Anspruch auf Vollständigkeit. Die Polymere besitzen einen Erweichungsbereich zwischen 65 und 175 °C.

Zur Optimierung der klebtechnischen Eigenschaften und des Aktivierungsbereiches lassen sich vorteilhaft klebkraftsteigernde Harze hinzusetzten. Der bevorzugte Anteil der Harze beträgt zwischen 2 und 50 Gew.-%, bezogen auf den Thermoplasten.

Als zuzusetzende klebrigmachende Harze sind die in der Literatur beschriebenen Klebharze einsetzbar. Genannt seien stellvertretend die Pinen-, Inden- und Kolophoniumharze, deren disproportionierte, hydrierte, polymerisierte, veresterte Derivate und Salze, die aliphatischen und aromatischen Kohlenwasserstoffharze, Terpenharze und Terpenphenolharze sowie C5-, C9- sowie andere Kohlenwasserstoffharze. Beliebige Kombinationen dieser und weiterer Harze können eingesetzt werden, um die Eigenschaften der resultierenden Klebmasse wunschgemäß einzustellen. Im allgemeinen lassen sich alle mit dem entsprechenden Thermoplasten kompatiblen (löslichen) Harze einsetzen, insbesondere sei verwiesen auf alle aliphatischen, aromatischen, alkylaromatischen Kohlenwasserstoffharze, Kohlenwasserstoffharze auf Basis reiner Monomere, hydrierte Kohlenwasserstoffharze, funktionelle Kohlenwasserstoffharze sowie Naturharze. Auf die Darstellung des Wissensstandes im "Handbook of Pressure Sensitive Adhesive Technology" von Donatas Satas (van Nostrand, 1989) sei ausdrücklich hingewiesen.

In einer weiteren bevorzugten Ausführung werden Epoxy-Harze hinzugeben. Das Molekulargewicht der Epoxy-Harze variiert von 100 g/mol bis zu maximal 10000 g/mol für polymere Epoxy-Harze.

Die Epoxy-Harze umfassen zum Beispiel das Reaktionsprodukt aus Bisphenol A und Epichlorhydrin, das Reaktionsprodukt aus Phenol und Formaldehyd (Novolak Harze) und Epichlorhydrin, Glycidyl Ester, das Reaktionsprodukt aus Epichlorhydrin und p-Amino Phenol.

Bevorzugte kommerzielle Beispiele sind z.B. Araldite™ 6010, CY-281™, ECN™ 1273, ECN™ 1280, MY 720, RD-2 von Ciba Geigy, DER™ 331, DER™ 732, DER™ 736, DEN™ 432, DEN™ 438, DEN™ 485 von Dow Chemical, Epon™ 812, 825, 826, 828, 830, 834, 836, 871, 872,1001, 1004, 1031 etc. von Shell Chemical und HPT™ 1071, HPT™ 1079 ebenfalls von Shell Chemical.

Beispiele für kommerzielle aliphatische Epoxy-Harze sind z.B. Vinylcyclohexandioxide, wie ERL-4206, ERL-4221, ERL 4201, ERL-4289 oder ERL-0400 von Union Carbide Corp.

Als Novolak-Harze können z.B. eingesetzt werden, Epi-Rez™ 5132 von Celanese, ESCN-001 von Sumitomo Chemical, CY-281 von Ciba Geigy, DEN™ 431, DEN™ 438, Quatrex 5010 von Dow Chemical, RE 305S von Nippon Kayaku, Epiclon™ N673 von DaiNipon Ink Chemistry oder Epicote™ 152 von Shell Chemical.

Weiterhin lassen sich als Harze auch Melamin-Harze einsetzen, wie z.B. Cymel™ 327 und 323 von Cytec.

Weiterhin lassen sich als Harze auch Terpenphenolharze, wie z.B. NIREZ™ 2019 von Arizona Chemical einsetzen.

Weiterhin lassen sich als Harze auch Phenolharze, wie z.B. YP 50 von Toto Kasei, PKHC von Union Carbide Corp. Und BKR 2620 von Showa Union Gosei Corp. einsetzen.

Weiterhin lassen sich als Harze auch Polyisocyanate, wie z.B. Coronate™ L von Nippon Polyurethan Ind., Desmodur™ N3300 oder Mondur™ 489 von Bayer einsetzen.

Neben Harzen lassen sich auch Weichmacher einsetzen. Hier können in einer bevorzugten Ausführung der Erfindung Weichmacher auf Basis von Polyglykolethern, Polyethylenoxiden, Phosphatestern, aliphatische Carbonsäureestern und/oder Benzoesäureestern eingesetzt werden. Weiterhin lassen sich auch aromatische Carbonsäureester, höhermolekulare Diole, Sulfonamide und Adipinsäureester einsetzen.

Weiterhin können optional Füllstoffe (z.B. Fasern, Ruß, Zinkoxid, Titandioxid, Kreide, Voll- oder Hohlglaskugeln, Mikrokugeln aus anderen Materialien, Kieselsäure, Silikate), Keimbildner, Blähmittel, Compoundierungsmittel und/oder Alterungsschutzmittel, z.B. in Form von primären und sekundären Antioxidantien oder in Form von Lichtschutzmitteln zugesetzt sein.

In einer weiteren Ausführungsform werden als Klebemassen Polyolefine, insbesondere Poly-α-olefine, eingesetzt, die einen Erweichungsbereich von größer 65 °C und kleiner 175°C aufweisen und sich ebenfalls nach der Verklebung während des Abkühlens wieder verfestigen. Von der Firma Degussa sind unter dem Handelsnamen Vestoplast™ unterschiedliche Hitze-aktivierbare Poly-α-olefine kommerziell erhältlich.
Die Polyolefin-aktivierbaren Klebemassen weisen in einer bevorzugten Ausführungsform statische Erweichungstemperaturen T_{E,A} oder Schmelzpunkte T_{S,A} von +65 °C bis 150 °C auf. Die Klebkraft dieser Polymere kann durch gezielte Additivierung gesteigert werden. So lassen sich z.B. Polyimin- oder Polyvinylacetat-Copolymere als klebkraftfördernde Zusätze verwenden.
In einer sehr bevorzugten Auslegung der Erfindung werden Copolyamide als thermoplastische Klebstoff eingesetzt. Diese sind z.B. von der Fa. Atofina kommerziell erhältlich.

### Elektrisch leitfähige Partikel

Als elektrisch leitfähige Partikel werden vorteilhaft Partikel mit einem Kupferkern oder einem Nickelkern eingesetzt. Die Ummantelung besteht sehr bevorzugt aus Silber oder aus Gold. Der Anteil der Ummantelung am Gesamtgewicht des Partikels beträgt bevorzugt zwischen 2 und 50 Gew-%, mehr bevorzugt zwischen 5 und 25 Gew-%. Die Partikel weisen in einer bevorzugten Auslegung eine kugelförmige Struktur auf. In einer weiter sehr bevorzugten Auslegung der Erfindung weisen die Partikel nur grob eine kugelförmige Struktur auf, die eine eher zackige Oberfläche besitzt, um die Verankerung der Partikel auf der Antenne bzw. auf dem Dual Interface Modul zu verbessern. Die Form der Kugeln wird dann mehr als Granulat bezeichnet.
Kommerziell sind solche Partikel von der Fa. Nanotechnology BV unter dem Handelsnamen Sil-Shield Ag/Ni und Ag/Cu erhältlich.

### Verfahren zur Herstellung

Die Klebemasse muss zur weiteren Verarbeitung zur Verklebung von elektrischen Modulen auf Kartenkörpern auf einem Trennpapier oder einem Trennliner zur Verfügung gestellt werden.

Die Beschichtung kann aus Lösung oder - sehr bevorzugt - aus der Schmelze erfolgen. Für den Auftrag aus der Schmelze wird - falls das Polymer in Lösung vorliegt - das Lösemittel bevorzugt in einem Aufkonzentrationsextruder unter vermindertem Druck abgezogen, wozu beispielsweise Ein- oder Doppelschneckenextruder eingesetzt werden können, die bevorzugt das Lösemittel in verschiedenen oder gleichen Vakuumstufen abdestillieren und über eine Feedvorwärmung verfügen. Dann wird über eine Schmelzdüse oder eine Extrusionsdüse beschichtet, wobei gegebenenfalls der Klebefilm gereckt wird, um die optimale Beschichtungsdicke zu erreichen. Für die Vermischung der Harze kann ein Kneter oder ein Doppelschneckenextruder zur Vermischung eingesetzt werden. Für die Vermischung mit den elektrisch leitfähigen Partikeln wird in einer sehr bevorzugten Auslegung das thermoplastische Polymere in sehr kleine Partikeln durch Vermahlung überführt. In einem zweiten Schritt wird dann durch Vermengung in z.B. einem Stephanrührer eine homogene Mischung aus thermoplastischem Kleber und elektrisch leitfähigen Partikeln hergestellt. Anschließend wird die Klebemasse in einem Einschneckenextruder aufgeschmolzen und anschließend durch eine Extrusionsdüse mit Bügelkanal beschichtet.

Als Trägermaterialien für die Klebemasse werden die dem Fachmann geläufigen und üblichen Materialien, wie Folien (Polyester, PET, PE, PP, BOPP, PVC, Polyimid), Vliese, Schäume, Gewebe und Gewebefolien sowie Trennpapier (Glassine, HDPE, LDPE) verwendet. Die Trägermaterialien sollten mit einer Trennschicht ausgerüstet sein. Die Trennschicht besteht in einer sehr bevorzugten Auslegung der Erfindung aus einem Silikontrennlack oder einem fluorierten Trennlack.

Die Erfindung betrifft weiterhin die Verwendung einer wie vorstehend beschriebenen Klebstofffolie zur Verklebung von Substraten unter Herstellung eines elektrisch leitfähigen Kontaktes der Substrate über die Verklebungsstelle, insbesondere zur Verklebung von elektrischen Modulen in Kartenkörpern. Vorzugsweise werden die Partikel unter Ausübung von Druck, insbesondere unter erhöhter, also über Raumtemperatur liegender Temperatur im Verklebungsschritt kompressiert und somit die elektrische Kontaktfläche erhöht, bezogen auf einen Zustand der Verklebung ohne Kompression. In sehr bevorzugter Weise beträgt die Temperatur im Verklebungsschritt zwischen 120 °C und 250 °C.

Als sehr vorteilhaft stellt es sich durch die Verklebung mit der erfindungsgemäßen Klebstofffolie heraus, wenn sich die Partikel nach der Verklebung mit den elektrischen Kontaktstellen unter Ausübung von Stress (z.B. durch Biegungen oder andere starke mechanische Beanspruchungen) mit den elektrischen Kontaktstellen verzahnen und somit der elektrische Kontakt erhalten bleibt, insbesondere bei einer Verklebung wie im vorstehenden Absatz dargestellt.

### Beispiele

### Beispiel 1

Platamid 2395 (Copolyamid) der Fa. Atofina wurde als 100 µm Pulver im Vakuum bei 40°C für 24 h getrocknet. Anschließend wurden 40 Gew.-% versilberte Kupferkugeln (Durchmesser 50 µm, 24 Gew.-% Silber) hinzugerührt und das Pulver in einem Fass für 24 h auf einem Fassroller vermengt.

### Beispiel 2

Platamid 2395 (Copolyamid) der Fa. Atofina wurde als 100 µm Pulver im Vakuum bei 40°C für 24 h getrocknet. Anschließend wurden 40 Gew.-% versilberte Nickelkugeln (Durchmesser 50 µm, 24 Gew.-% Silber) hinzugerührt und das Pulver in einem Fass für 24 h auf einem Fassroller vermengt.

### Beschichtung

Die Beispiele 1 und 2 wurden in einem SIG Einschneckenextruder aufgeschmolzen und durch eine Breyerdüse bei 180°C beschichtet. Der Klebefilm wird auf ein Glassine Trennpapier mit beidseitiger abgestufter Silikonisierung abgelegt. Der Masseauftrag der Klebemasse betrug nach der Beschichtung ca. 60 g/m², wobei die elektrisch leitfähigen Partikel unbeschadet den Extrusionsprozess überstehen und auf dem Träger mit einem durchschnittlichen Durchmesser von 50 µm aus der Klebemasse herausragen.

### Implantierung der elektrischen Module

Die Implantierung der elektrischen Module in den Kartenkörper erfolgte mit einem Implanter der Fa. Ruhlamat.
Es wurden folgende Materialien eingesetzt:
Elektrische Module: Philips Mifare
PVC-Karten mit geätzter Multitape Antenne.

In einem ersten Schritt wurden die Proben aus den Beispielen 1 und 2 mit der Maschine Mühlbauer CML 3400 mit einem Laminierdruck von 3 bar auf den Modulgurt laminiert.
Dann wurden die elektrischen Module in die passende Kavität des Kartenkörpers implantiert.
Es wurden folgende Parameter für alle Beispiele angewendet:
Heizschritte: 1
Stempeltemperatur: 205°C
Zeit: 1 x 1.5 s
Kühlschritt: 1x 800 ms, 25°C
Druck: 200 N pro Modul

### Testmethoden:

### Iso-Bending A)

Der Iso-Bending Test wird analog der Iso/IEC-Norm 10373 : 1993 (E) - section 6.1 durchgeführt.
Der Test gilt als bestanden, wenn insgesamt mehr als 4000 Biegungen erreicht werden. Zur Überprüfung der elektrischen Kontaktierung wird der Widerstand des Modules gemessen nach allen 250 Biegungen. Der Test gilt nur dann als bestanden, wenn die elektrische Leitfähigkeit nicht abfällt.

### Iso-Bending B)

Der Iso-Bending Test wurde analog A) durchgeführt, jedoch nach einer Lagerung der Proben für 15 Tage in einem Klimawechseltest. Das Klima wurde zwischen -30 °C und 65 °C gewechselt, wobei bei -30 °C die Luftfeuchtigkeit 0 % beträgt und bei +65 °C +95 %. Alle 6 h wurde das Klima zwischen den beiden Temperaturen und Luftfeuchtigkeiten gewechselt.

### Ergebnisse:

Die mit den erfinderischen Klebemassen hergestellten Chipkarten wurden nach den Testmethoden A und B ausgetestet. Die Ergebnisse sind in der Tabelle 1 dargestellt.

**Tab. 1**

| Beispiele | Testmethode A | Testmethode B |
|---|---|---|
| 1 | > 4000 | > 4000 |
| 2 | > 4000 | > 4000 |

Tabelle 1 kann entnommen werden, dass die erfinderischen Beispiele die wichtigsten Kriterien für eine Dual Interface Chipkarte bestanden haben und somit sehr gut zur Verklebung von elektrischen Modulen auf Kartenkörpern geeignet sind. Nach dem Durchlauf der Prüfmethoden blieb die anisotrope Leitfähigkeit erhalten und die Klebemassen zeigten ebenfalls keine Schwächen nach dem Durchlauf des Klimawechseltests.

## Patentansprüche

1. Klebstofffolie, insbesondere zur Verklebung von elektrischen Modulen in Kartenkörpern, bestehend zumindest aus einer Schicht eines Klebesystems auf Basis zumindest einer hitze-aktivierbaren Klebemasse, **dadurch gekennzeichnet, dass**
• die Erweichungstemperatur des Klebesystems im Bereich von 65 °C bis 165 °C liegt,
• dem Klebesystem elektrisch leitfähige Partikel beigemischt sind,
wobei die Partikel im Durchschnitt einen Durchmesser von 25 bis 100 µm aufweisen, mit der Maßgabe, dass der durchschnittliche Durchmesser der leitfähigen Partikel größer ist als die Schichtdicke des Klebesystems,
• die leitfähigen Partikel einen Kupfer- oder Nickelkern aufweisen.

2. Klebstofffolie nach zumindest einem der vorangehenden Ansprüche, **dadurch gekennzeichnet, dass**
die leitfähigen Partikel eine Gold- oder eine Silberummantelung aufweisen.

3. Klebstoffolie nach zumindest einem der vorangehenden Ansprüche, **dadurch gekennzeichnet, dass**
der durchschnittliche Durchmesser der leitfähigen Partikel zumindest 5 µm größer ist als die Schichtdicke des Klebesystems.

4. Klebstofffolie nach zumindest einem der vorangehenden Ansprüche, **dadurch gekennzeichnet, dass**
die elektrisch leitfähigen Partikel zu einem Anteil von 2 bis 60 Gew.-%, bezogen auf die Klebemasse ohne Partikel, in dem Klebesystem vorliegen

5. Klebstofffolie nach zumindest einem der vorangehenden Ansprüche, **dadurch gekennzeichnet, dass**
die elektrisch leitfähigen Partikel in dem Klebesystem homogen verteilt sind.

6. Klebstofffolie nach zumindest einem der vorangehenden Ansprüche, **dadurch gekennzeichnet, dass**
die Dicke der Schicht des Klebesystems im Bereich von 20 bis 95 µm, insbesondere von 30 bis 80 µm liegt.

7. Klebstofffolie nach zumindest einem der vorangehenden Ansprüche, **dadurch gekennzeichnet, dass**
als hitze-aktivierbare Klebemassen Thermoplasten eingesetzt werden.

8. Verwendung einer Klebstofffolie gemäß zumindest einem der vorstehenden Ansprüche zur Verklebung von Substraten unter Herstellung eines elektrisch leitfähigen Kontaktes der Substrate über die Verklebungsstelle, insbesondere zur Verklebung von elektrischen Modulen in Kartenkörpern, **dadurch gekennzeichnet, dass** die Partikel unter Ausübung von Druck im Verklebungsschritt kompressiert werden und somit die elektrische Kontaktfläche erhöht wird, bezogen auf einen Zustand der Verklebung ohne Kompression; wobei insbesondere die Kompression unter über Raumtemperatur liegender Temperatur durchgeführt wird.
